(19)

Europäisches
Patentamt
European
Patent Office
Office européen
des brevets

(11) **EP 1 508 969 B1**

(12) **EUROPEAN PATENT SPECIFICATION**

(45) Date of publication and mention
of the grant of the patent:
**14.10.2009 Bulletin 2009/42**

(51) Int Cl.:
***H04L 25/03*** *(2006.01)*       ***H03H 21/00*** *(2006.01)*

(21) Application number: **04019302.1**

(22) Date of filing: **13.08.2004**

(54) **Multipath distortion eliminating filter**

Filter zur Beseitigung von Mehrwegverzerrungen

Filtre pour éliminer des distorsions multivoies

(84) Designated Contracting States:
**DE FR GB**

(30) Priority: **19.08.2003 JP 2003207867**

(43) Date of publication of application:
**23.02.2005 Bulletin 2005/08**

(73) Proprietor: **Pioneer Corporation**
**Meguro-ku,**
**Tokyo (JP)**

(72) Inventors:
 • **Yamamoto, Yuji**
  **c/o Kawagoe Koujou**
  **Pioneer Corp.**
  **Kawagoe-shi,**
  **Saitama-ken 350-8555 (JP)**
 • **Kubuki, Toshiaki**
  **c/o Kawagoe Koujou**
  **Pioneer Corp.**
  **Kawagoe-shi,**
  **Saitama-ken 350-8555 (JP)**

(74) Representative: **Bohnenberger, Johannes et al**
**Meissner, Bolte & Partner**
**Widenmayerstrasse 48**
**80538 München (DE)**

(56) References cited:
 • **VANESSA Y YANG ET AL: "A Vector Constant Modulus Algorithm for Shaped Constellation Equalization" IEEE SIGNAL PROCESSING LETTERS, IEEE SERVICE CENTER, PISCATAWAY, NJ, US, vol. 5, no. 4, 1 April 1998 (1998-04-01), pages 89-91, XP011060025 ISSN: 1070-9908**
 • **JONES, D L: "A Normalized Constant-Modulus Algorithm" SIGNALS, SYSTEMS AND COMPUTERS, 1995. 1995 CONFERENCE RECORD OF THE TWENTY-NINTH ASILOMAR CONFERENCE ON, vol. 1, 30 October 1995 (1995-10-30), - 2 November 1995 (1995-11-02) pages 694-697, XP002480806 Pacific Grove, CA, USA**

## Description

BACKGROUND OF THE INVENTION

The present invention relates to a multipath distortion eliminating filter which is mounted on an FM receiver to eliminate multipath distortion occurring in reception waves.

Among problems of importance in FM radio broadcasts is interference that results frommultipath distortion of the reception waves. Multipath distortion is the phenomenon that an FM reception wave signal, which should basically have a constant amplitude, varies in amplitude because of mutual interference between a plurality of incoming waves having different phases and different field intensities due to multiple wave propagation. In particular, FM receivers mounted on mobile units, such as a car radio, sometimes encounter multipath distortion with sharp fluctuations in amplitude since the state of reception varies with movement. Multipath distortion can cause pulsed noise in FM demodulation signals, contributing to a deterioration in reproduction sound quality.

Conventionally, mobile FM receivers such as a car radio have exercised such controls as ARC (Automatic Reception Control) in order to reduce noise included in the reproduction sound demodulated. In the methods of reducing noise through ARC control and the like, however, the noise suppression has been achieved at the cost of sound quality of some sort, including the stereophonic feel of the demodulated sound. These methods have thus been far from achieving substantial elimination of the multipath distortion.

Now, with the speedup of digital signal processing technologies in recent years, attention is being given to digital FM receivers in which FM reception waves downconverted into intermediate frequency signals are converted into digital signals for digitalized signal processing at the subsequent stages, including wave detection. In such digitalized FM receivers, multipath distortion can be eliminated through the use of adaptive digital filters that have characteristics inverse to the transfer functions of the transmission paths from broadcast stations to the receivers.

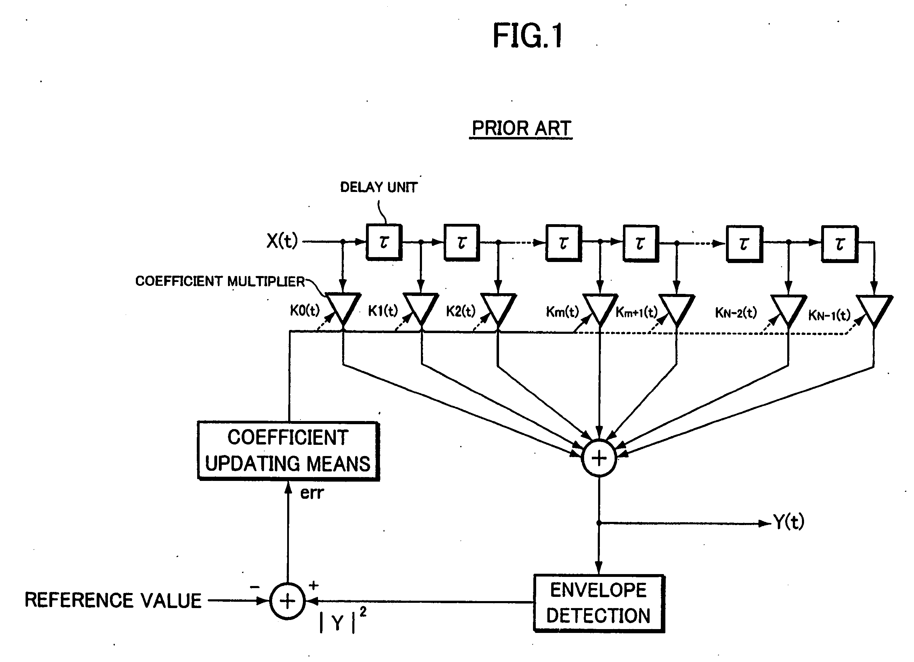

Fig. 1 shows an example of the adaptive digital filter for eliminating multipath distortion, which is made of an FIR type filter. Tap coefficients Km of this filter are updated according to the algorithm called CMA (Constant Modulus Algorithm). More specifically, adaptive processing is exercised in consideration of the characteristic of FM signals that the amplitude should basically be constant. Here, the tap coefficients Km are updated and converged so as to minimize an error err between the envelope (amplitude) of the output signal past the filter and a reference value, whereby a filter characteristic for eliminating multipath distortion is provided.

By the way, for mobile FM receivers, there exists time periods in which reception waves might be seriously suppressed in field intensity due to such reasons as Doppler shift resulting from vehicle movement. When these reception wave signals of suppressed field intensity are subjected to the arithmetic processing of updating the tap coefficients Km on the basis of the conventional CMA method, the extremely small values of the signals to be handled cause quantization-based rounding of fractions, or round-off errors etc. There has thus been the problem that it takes long for the tap coefficients Km to converge.

Meanwhile, adaptive digital filters require that the adaptive processing be performed at high speed so as to follow changes in the state of reception due to vehicle movement. There has thus been the problem that the adaptive processing of the filters cannot follow the changes in the state of reception, failing to eliminate multipath distortion sufficiently when the foregoing errors or delays occur during the convergence computing of the tap coefficients Km.

A typical adaptive digital equaliser is disclosed in : V.Y. YANG ET AL, " A Vector Constant Modulus Algorithm for Shaped Constellation Equalization", IEEE Signal Processing Letters, vol 5, no. 4, April 1998, pages 89-91.

SUMMARY OF THE INVENTION

The present invention has been achieved in view of the conventional problems described above. It is thus an object of the present invention to provide a multipath distortion eliminating filter to be mounted on an FM receiver, which performs proper adaptive processing at high speed and thereby eliminates multipath distortion with reliability, for example.

This object is achieved by the features of independent claim 1. Further embodiments are the subject of dependent claims 2-4.

BRIEF DESCRIPTION OF THE DRAWINGS

These and other objects and advantages of the present invention will become clear from the following description with reference to the accompanying drawings, wherein:

Fig. 1 is a block diagram showing the configuration of a conventional adaptive filter;
Fig. 2 is a block diagram showing the configuration of an FM receiver according to the present invention;
Fig. 3 is a block diagram showing the configuration of an adaptive filter according to an embodiment of the present invention;

Figs. 4A and 4B are block diagrams showing configurations of the envelope detection means shown in Fig. 3;

Fig. 5 is a block diagram showing a configuration of the coefficient updating means shown in Fig. 3;

Fig. 6 is a block diagram showing another configuration of the coefficient updating means shown in Fig. 3; and

Figs. 7A and 7B are graphs for comparing the results of the signal response waveforms obtained from an FM receiver on which an adaptive filter according to the embodiment of the present invention is mounted, and an FM receiver on which a conventional adaptive filter is mounted, respectively.

DETAILED DESCRIPTION OF THE PREFERRED EMBODIMENTS

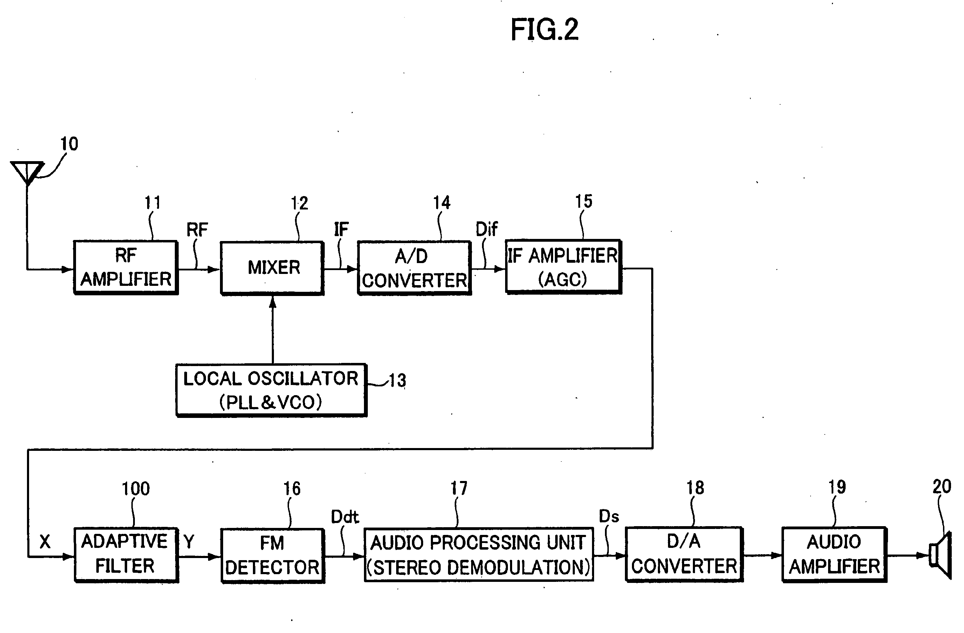

Hereinafter, a most preferred embodiment of the present invention will be described with reference to the drawings. Description will initially be given of an FM receiver on which an adaptive filter 100 according to the present embodiment is mounted. Fig. 2 is a block diagram showing the configuration of a digital FM receiver such as a car radio.

In the diagram, the FM-broadcast reception wave received by an antenna circuit 10 is amplified by an RF amplifier (radio frequency amplifier) 11. The resulting RF signal is output to a mixer 12. The mixer 12 mixes the RF signal with a local oscillation signal from a local oscillator 13, which is composed of a PLL circuit, a VCO circuit, etc. An intermediate frequency signal IF of downconverted frequency is thus generated, and supplied to an A/D converter 14. The A/D converter 14 converts the intermediate frequency signal IF, an analog signal, into a digital sample value signal (hereinafter, "digital signal") Dif at predetermined regular sampling periods.

The intermediate frequency signal Dif, a digitally-converted signal, is amplified by an IF amplifier (intermediate frequency amplifier) 15. The IF amplifier 15 has an automatic gain control (AGC) function. It outputs the intermediate frequency signal Dif of constantly stable amplitude to the adaptive filter 100, an FM detector 16, and the like in subsequent stages regardless of the field intensity of the reception wave.

The adaptive filter 100 applies digital signal processing chiefly intended for the elimination of multipath distortion to the intermediate frequency signal Dif of adjusted amplitude, and outputs the resultant to the FM detector 16 in the subsequent stage. The configuration and operation of this adaptive filter 100 will be detailed later.

The FM detector 16 applies digital detection processing of a predetermined detection system to the intermediate frequency signal Dif past the adaptive filter 100, thereby generating a detection signal Ddt which is a composite signal. Then, in an audio processing unit 17, the detection signal Ddt is subjected to mute processing, high-cut control processing, and the like on the basis of the field intensity of the reception wave. The resultant is also demodulated in stereo, thereby being separated into right and left audio signals Ds.

Then, the audio signals Ds are converted into respective analog signals by a D/A converter 18. An audio amplifier 19 in the subsequent stage amplifies and supplies the analog audio signals to speakers 20, whereby the received FM-broadcast sound is reproduced.

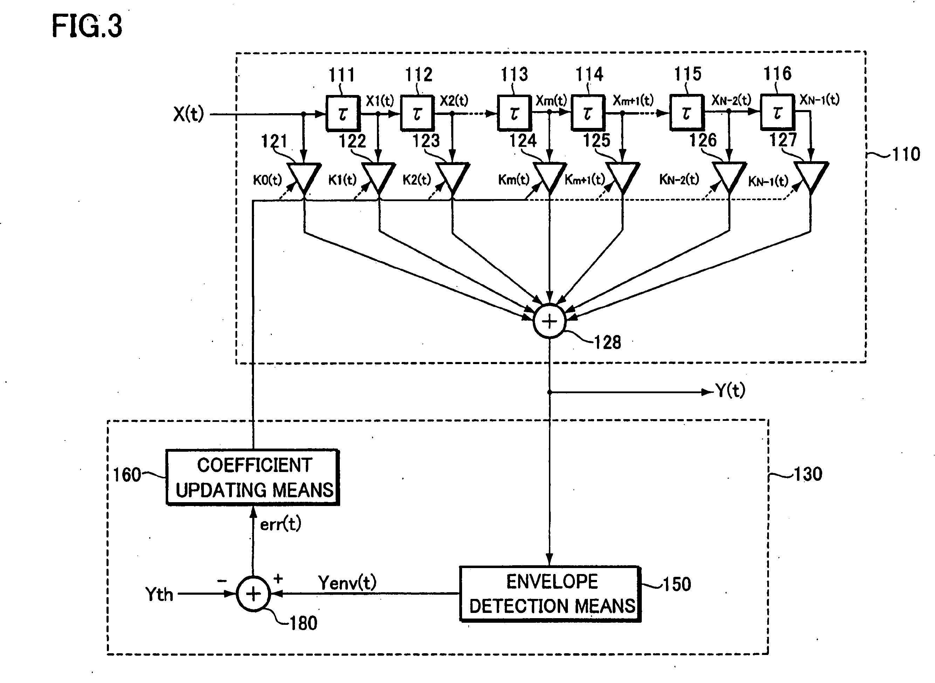

Next, the adaptive filter 100 for eliminating multipath distortion occurring in the FM reception wave will be described with reference to the drawings. Fig. 3 is a block diagram showing the configuration of the adaptive filter 100. Although operations of complex values are needed originally, the shown case will deal with a simplified configuration where a unit delay time $\tau$ is 1/4 with respect to the signal period of an input signal X(t). This adaptive filter 100 comprises an FIR type digital filter 110 and adaptive processingmeans 130. For the input signal X (t) , the digital filter 110 receives the FM intermediate frequency signal Dif that is A/D-converted. The adaptive processing means 130 performs adaptive processing on the digital filter 110 so that the digital filter 110 has a filter characteristic for functioning as a so-called inverse filter which eliminates multipath distortion occurring in the FM intermediate frequency signal.

Referring to Fig. 3, description will be given about the configuration of the digital filter 110. The digital filter 110 is made of an FIR (Finite Impulse Response) type filter of order N, including (N - 1) delay units 111-116, N coefficient multipliers 121-127, and an adder 128. Here, the order N of the digital filter 110 is determined to be an appropriate number in consideration of the frequency of the input signal, the operation accuracy of the filter, the period available for operation (critical path), etc.

When the input signal X(t) of the digital filter 110 is input to the delay unit 111 in the initial stage, the delay unit 111 holds a sampled value of the input signal X(t) in synchronization with a reference clock, or by the unit delay time $\tau$, and outputs it to the delay unit 112 in the subsequent stage. Similarly, the delay unit 112 delays the delayed value X1 (t) of the input signal by one reference clock (unit delay time $\tau$), and outputs it to the delay unit in the subsequent stage. The subsequent delay units 113-116 also shift the delayed values of the input signal X(t) in succession while accumulating the delay times in synchronization with the reference clock.

The coefficient multipliers 121-127 multiply the input signal X(t) and the delayed values X(t-1), X(t-2), ···, X(t-N+1), which are held in the delay units 111-116 and are delayed by one, two, ···, (N-1) unit delay times, by their respective filter coefficients (hereinafter, referred to as "tap coefficients"). The resultants are output to the adder 128. The adder 128 adds these coefficient-multiplied signals, and outputs the resultant as an output signal Y(t) of the digital filter 110.

Next, description will be given about the adaptive processing means 130 which performs adaptive processing on the digital filter 110 described above. Incidentally, the adaptive processing means 130 performs processing for updating the tap coefficients Km of the digital filters 110 at regular operation periods for final convergence so that the output signal Y (t) of the filter has a constant amplitude Yenv(t).

The adaptive processing means 130 comprises envelope detection means 150 for detecting an envelope Yenv (t) of the output signal Y(t) corresponding to the amplitude thereof, a comparator 180, and coefficient updating means 160.

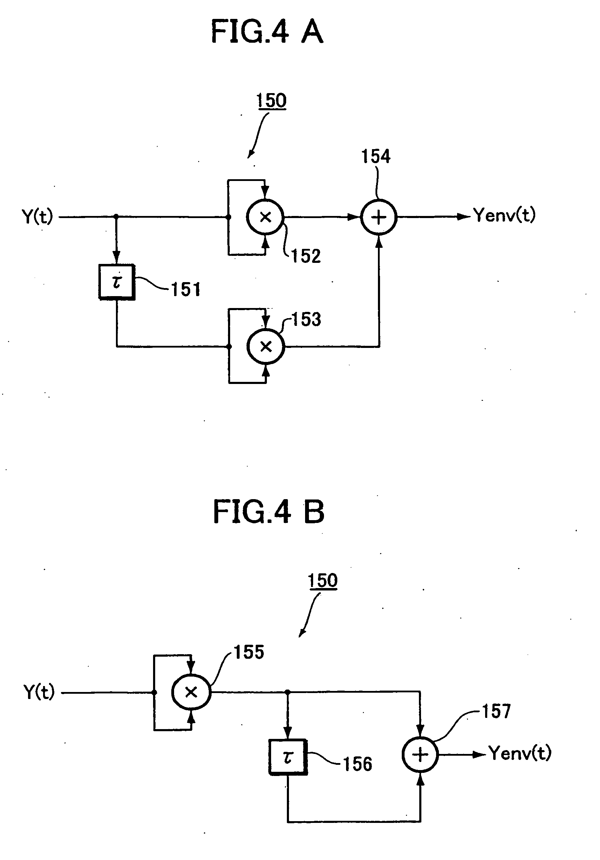

The envelope detection means 150 detects the envelope Yenv (t) of the output signal Y(t), which corresponds to the amplitude of the same, based on the equation (1) as seen later. Figs. 4A and 4B are block diagrams showing examples of configuration of the envelope detection means 150.

In Fig. 4A, the envelope detection means 150 comprises a delay unit 151, multipliers 152 and 153, and an adder 154. The delay unit 151 holds the filter output signal Y(t) by the unit delay time $\tau$ in synchronization with the reference clock, and outputs the delayed value Y(t-1) of the delayed output signal to the multiplier 153. The multipliers 152 and 153 determine the squares of the filter output signal Y (t) and the delayed value Y(t-1), respectively. The adder 154 adds the squared values output from the multipliers 152 and 153 to determine the envelope Yenv (t) of the filter output signal Y(t).

$$Yenv(t) = Y(t)^2 + Y(t-1)^2 \dots (1)$$

The envelope detection means 150 may have the configuration shown in Fig. 4B. In this case, the envelope detection means 150 comprises a multiplier 155, a delay unit 156, and an adder 157. The multiplier 155 determines the square of the filter output signal Y (t) , and outputs it to the delay unit 156 and the adder 157. The delay unit 156 holds the squared value of the filter output signal Y (t) by the unit delay time $\tau$, and outputs the value delayed by the time $\tau$ to the adder 157. The adder 157 adds the squared value of the filter output signal Y(t) and the value delayed by the time $\tau$ to determine the envelope Yenv (t) of the filter output signal Y (t) .

According to the envelope detection means 150 configured as shown in Fig. 4B, the envelope Yenv(t) based on the equation (1) can be determined by using the configuration with a smaller number of computing units. This means a relative increase in operation speed.

Returning to Fig. 3, the comparator 180 subtracts a reference value Yth, which is a preset value, from the envelope Yenv(t) of the filter output signal, i.e., determines an error err(t) based on the following equation (2). The error err(t) is output to the coefficient updating means 160.

$$err(t) = Yenv(t) - Yth \dots (2)$$

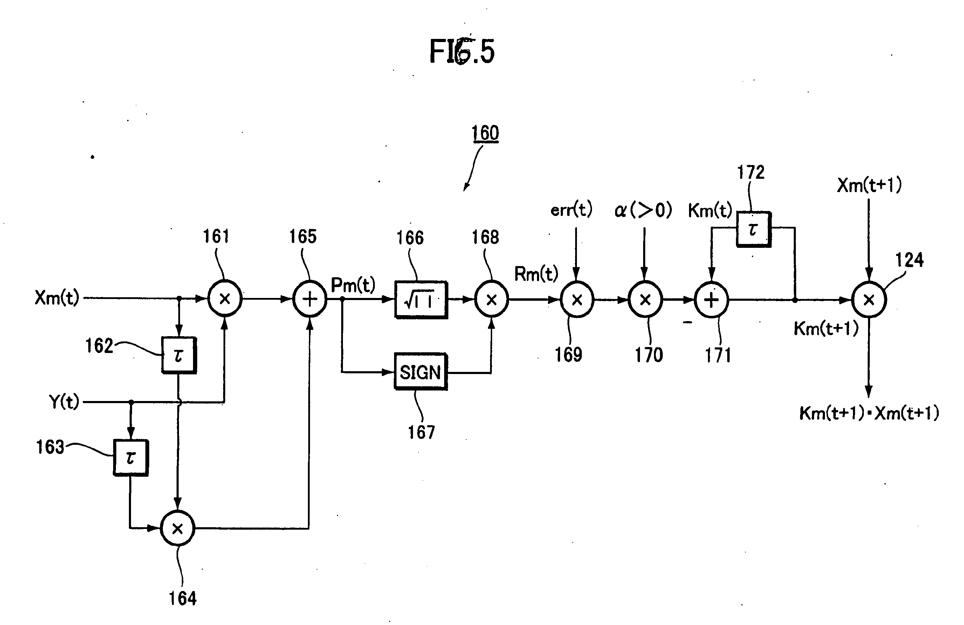

The coefficient updating means 160 updates the tap coefficients Km of the respective coefficient multipliers 121-127 so as to minimize the error err (t) which is the difference between the reference value Yth and the envelope Yenv (t) of the filter output signal. A concrete configuration of the coefficient updating means 160 is shown in Fig. 5. Fig. 5 is a block diagram of coefficient updating means 160 which updates the tap coefficient Km of the coefficient multiplier 124 in the mth stage. Similar coefficient updating means 160 are provided for the coefficient multipliers 121-127 in the zeroth, first, second, ···, (N-1)th stages, respectively.

Now, the coefficient updating means 160 for updating the tap coefficient Km will be described representatively with reference to Fig. 5. For input variables, the coefficient updating means 160 receives the delayed value Xm (t) of the input signal X (t) , delayed by m unit delay times, along with the filter output signal Y(t) and the error err (t) described above. The coefficient updating means 160 determines a tap coefficient Km(t+1) to be used at the next operation time, and supplies it to the coefficient multiplier 124 in the mth stage.

Specifically, the tap coefficient Km is updated based on tap coefficient updating equations given by the following equations (3-1), (3-2), (3-3), and (3-4):

$$Km(t+1) = Km(t) - \alpha \cdot err(t) \cdot Rm(t) \dots (3-1).$$

Here,

$$Pm(t) = Xm(t) \cdot Y(t) + Xm(t-1) \cdot Y(t-1) \ldots (3-2),$$

$$Rm(t) = SIGN \{Pm(t)\} \cdot \sqrt{|Pm(t)|} \ldots (3-3),$$

where

$$SIGN(Pm) = 1 \ (Pm>0), \ 0 \ (Pm = 0), \ or \ -1 \ (Pm<0) \ldots (3-4),$$

and $\alpha > 0$.

The delayed value Xm(t) and the filter output signal Y (t) input to the coefficient updating means 160 are multiplied by each other in a multiplier 161, and output to an adder 165 in the subsequent stage. Incidentally, the delayed value Xm(t) of the input signal and the filter output signal Y(t) are also held in delay units 162 and 163 by the unit delay time τ. These held values, i.e. , the values of the respective signals at the time one reference clock before are input to a multiplier 164. The multiplier 164 multiplies these delayed values, and outputs the resultant to the adder 165.

The adder 165 adds the values output from the multipliers 161 and 164, and outputs a value Pm(t) which is based on the foregoing equation (3-2). Here, the value Pm(t) is an amount corresponding to the correlation between the delayed value Xm(t) of the input signal and the filter output signal Y(t). The value Pm(t) will be referred to also as the amount of correlation.

Next, the value Pm(t) output from the adder 165 is converted into a value Rm(t) through compression conversion processing based on the foregoing equation (3-3) . That is, a square root computing unit 166 determines a square root of the absolute value of the value Pm(t), and outputs it to a multiplier 168 in the subsequent stage. Meanwhile, a sign converter 167 converts the sign of the value Pm(t) into 1, 0, or -1 as given by the equation (3-4), and outputs it to the multiplier 168. The multiplier 168 multiplies these values to convert the value Pm(t) into the value Rm(t) for output. The Rm(t) is given the compression conversion processing expressed by the following equations (4-1) and (4-2):
When $Pm(t) \geq 0$,

$$Rm(t) = \sqrt{|Pm(t)|} \ldots (4-1).$$

When $Pm(t) < 0$,

$$Rm(t) = -\sqrt{|Pm(t)|} \ldots (4-2).$$

A multiplier 169 multiplies the value Rm(t) given the compression conversion processing and the error err(t) determined by the comparator 180 described above, and outputs the resultant to a multiplier 170 in the subsequent stage. The multiplier 170 multiplies the output value of the multiplier 169 by an attenuation coefficient $\alpha$, a constant, and outputs the resultant to the negative input terminal of a subtractor 171. Incidentally, the attenuation coefficient $\alpha$ is a positive value which is set appropriately. The attenuation coefficient $\alpha$ is determined through experiments in advance in view of a balance between the time of convergence of the tap coefficient Km (t) and the stability of the coefficient update during the adaptive processing of the filter.

A delay unit 172 holds the tap coefficient Km (t) in the operation period in question (at current time) , and outputs the tap coefficient Km(t) to the positive input terminal of the subtractor 171 mentioned above. The subtractor 171 subtracts the output value of the multiplier 170 fromthe tap coefficient Km (t) at the present operation period, thereby determining a tap coefficient Km(t+1) for the next operation period. The subtractor 171 outputs the resultant to the coefficient multiplier 124. Consequently, the tap coefficient Km(t) of the coefficient multiplier 124 in the mth stage is updated.

Note that the coefficient multipliers 121-126 in the zeroth, first, second, ···, (N-1) th stages are also provided with similar coefficient updating means 160, respectively. The individual tap coefficients Km(t) are thus updated within the operation period in question. Then, the tap coefficients Km(t) are updated repeatedly so that the error err (t) between the envelope Yenv (t) of the output signal and the reference value Yth finally becomes zero. Through the operations of converging the individual tap coefficients Km(t), the adaptive processing of the digital filter 110 for eliminating multipath distortion can be executed accurately.

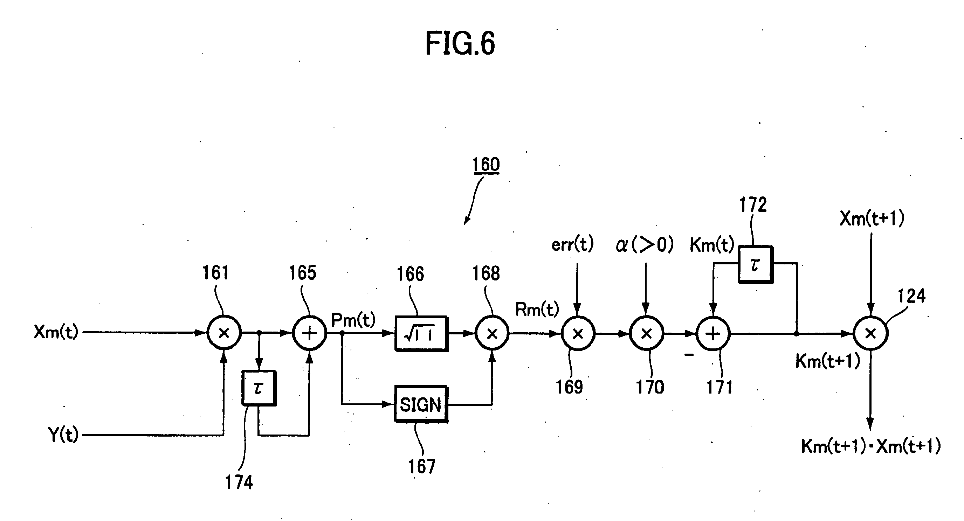

Incidentally, the value Pm(t) of the amount of correlation mentioned above may be computed by an arithmetic circuit having the configuration shown in Fig. 6. Fig. 6 is a block diagram showing the configuration of the coefficient updating means 160, or a diagram showing another embodiment. In the diagram, the same components as those shown in Fig. 5 are designated by identical reference numerals or symbols.

As shown in Fig. 6, the multiplier 161 multiplies the delayed value Xm(t) of the input signal and the filter output signal Y (t) , and outputs the resultant to the adder 165 and a delay unit 174 in the subsequent stage. The delay unit 174 holds the multiplied value Xm(t) · Y(t) by the unit delay time τ, and outputs a delayed value Xm(t-1) · Y(t-1) to the adder 165.

The adder 165 adds the respective outputs of the multiplier 161 and the delay unit 174 to determine the value Pm(t) of the amount of correlation based on the equation (3-2).

According to the adaptive filter 100 having the coefficient updating means of the configuration shown in Fig. 6, the value Pm(t) of the amount of correlation based on the equation (3-2) can be determined with a smaller number of computing units. It is therefore possible to save the hardware resource and improve the operation speed.

In the adaptive filter 100 having such a configuration, the coefficient updating means 160 applies the compression conversion processing based on the equation (3-3) to the value Pm(t), or the amount of correlation between the delayed value Xm(t) of the input signal and the filter output signal Y(t) . Consequently, even when the reception wave is seriously suppressed in field intensity due to multipath distortion and the value Pm(t) is as extremely small as, e.g.,

$$\mathrm{Pm(t)} = 0.00000001,$$

the foregoing compression conversion processing can determine the amount of update of the tap coefficient by using

$$\mathrm{Rm(t)} = 0.0001.$$

Since the number of digits to be handled is smaller, it is possible to improve the operation accuracy.

Moreover, if the digital operation for updating the tap coefficient is performed on the basis of the conventional MCA method, at least three times of multiplications are required. There have thus been the problems that such errors as numeric overflow and rounded fractions can occur easily in the course of the arithmetic processing, and also it takes long for the tap coefficient Km(t) to converge. According to the present coefficient updating means 160, on the other hand, the application of the foregoing compression conversion processing to the amount of correlation, or the value Pm (t) , can avoid those problems occurring in the conventional method, and enhance the stability during the adaptive processing.

Consequently, even when the FM reception wave signal is seriously suppressed in amplitude due to multipath distortion, it is possible to converge the tap coefficient Km(t) accurately at high speed.

Incidentally, the foregoing compression conversion processing for converting the value Pm(t), or the amount of correlation, into the value Rm(t) need not necessarily use the conversion function given by the equation (3-3) which determines a square root. For example, the same advantageous effects can also be obtained based on functions for calculating roots of higher order, such as a cube root. It is also possible to use conversion functions based on a logarithmic function and the like, for example.

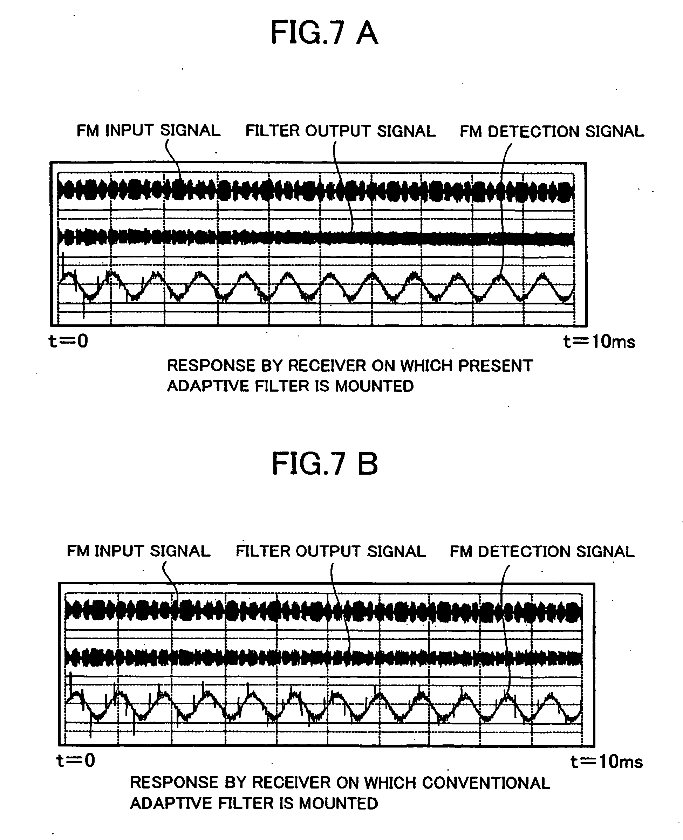

Fig. 7A is a graph showing examples of response waveforms in an FM receiver on which the adaptive filter 100 according to the present embodiment is mounted. The response waveforms show a filter output signal which is obtained through filtering processing on an FM input signal having multipath distortion components, and an FM detection signal which is obtained through detection on the filter output signal, respectively. Fig. 7B is a graph for comparison, showing conventional response waveforms with respect to the same FM input signal as in Fig. 7A. The response waveforms are of a filter output signal obtained by the conventional CMA method, and an FM detection signal thereof. This experiment was conducted under the following conditions: an FM input signal frequency of 10 MHz; a multipath D/U ratio of 1 dB; and a multipath delay of 13 μsec. The filter specifications were a tap order N of 130 and a sampling period of 40 MHz.

As shown in Fig. 7A, when the filteringprocessing of the present adaptive filter 100 was applied to the FM input signal havingmultipath distortion, the filter output signal converged to an almost constant amplitude within 10 msec. This shows that most of the multipath distortion components occurring in the input signal were eliminated. As a result, pulsed noise seen in the FM detection signal was also eliminated. Thus, according to the present adaptive filter 100, it is possible to perform adaptive processing at higher speed with higher reliability than by the conventional CMA method.

The foregoing embodiment has dealt with the case where the present invention is applied to a digital filter that is formed as an FIR type. It is understood, however, that the present invention is not limited to FIR type digital filters, but may be applied to digital filters of IIR type and the like.

**Claims**

1.   A multipath distortion eliminating filter (100) comprising:

a digital filter (110) having a plurality of coefficient multipliers (121-127) each having a tap coefficient (Km), for applying a filter operation processing to a digital reception signal, as an input signal (X(t)), containing a multipath-based distortion component, to eliminate the distortion component and outputting an output signal (Y(t));
error detection means (150, 180) for detecting an error (err(t)) between an envelope value (Yenv(t)) which is a square of amplitude of said output signal (Y(t)) and a reference value (Yth); and
coefficient updating means (160) for computing a filter characteristic of the digital filter so as to minimize said error detected, and updating each of the tap coefficents of said digital filter based on the result computed, wherein said coefficient updating means is adapted to determine an amount of correlation (Pm(t))between a delayed value (Xm(t)) of said input signal input to each of the coefficient multipliers of said digital filter and said output signal, and to determine an amount of update (Km(t+1)) of the tap coefficient corresponding to the delayed value of said input signal based on a multiplied value determined by multiplying said amount of correlation processed by a compression conversion processing (166, 167) and said error,
**characterized in that**
said compression conversion processing is an arithmetic processing for converting the amount of correlation into a root of an absolute value thereof to which a sign of the amount of correlation is attached .

2.   The multipath distortion eliminating filter according to claim 1, wherein said compression conversion processing is an arithmetic processing for converting the amount of correlation into a square root of an absolute value thereof to which a sign of the amount of correlation is attached.

3.   The multipath distortion eliminating filter according to claim 1 or 3, wherein
said coefficient updating means comprises:

a multiplier (161) for multiplying said delayed value of said input signal and said output signal in an operation period in question;
storing means (174) for holding the multiplied value determined by said multiplier for a unit delay time; and
an adder (165) for adding the multiplied value and a stored value stored in said storing means,
wherein said coefficient updating means conducts computation with the added value determined by said adder as the amount of correlation.

4.   The multipath distortion eliminating filter according to any one of claims 1, 3, and 4, wherein
said error detection means comprises:

a multiplier (155, 161) for determining a square of said output signal in an operation period in question;
storing means (156, 174) for holding the squared value determined by said multiplier for a unit delay time;
an adder (157, 165) for adding the squared value and a stored value stored in said storing means; and
a comparator (180) for comparing the added value (Yenv(t)) determined by said adder with said reference value (Yth).

**Patentansprüche**

1.   Mehrwegverzerrungsbeseitigungsfilter (100), das Folgendes aufweist:

ein Digitalfilter (110), das eine Vielzahl von Koeffizientenvervielfachern (121-127) mit jeweils einem Abzweigkoeffizienten (Km) hat, zum Anwenden einer Filteroperationsverarbeitung an einem digitalen Empfangssignal als einem Eingangssignal (X(t)), das eine mehrwegbasierte Verzerrungskomponente enthält, um die Verzerrungskomponente zu eliminieren und ein Ausgangssignal (Y(t)) auszugeben;

Fehlerdetektiereinrichtungen (150, 180) zum Detektieren eines Fehlers (err(t)) zwischen einem Hüllkurvenwert (Yenv(t)), der ein Amplitudenquadrat des Ausgangssignals (Y(t)) ist, und einem Referenzwert (Yth); und

eine Koeffizientenaktualisierungseinrichtung (160) zum Berechnen einer Filtercharakteristik des Digitalfilters, um **dadurch** den detektierten Fehler zu minimieren, und zum Aktualisieren jedes der Abzweigkoeffizienten des Digitalfilters auf der Basis des errechneten Resultats, wobei

die Koeffizientenaktualisierungseinrichtung geeignet ist, einen Korrelationsbetrag (Pm(t)) zwischen einem verzögerten Wert (Xm(t)) des in jeden der Koeffizientenvervielfacher des Digitalfilters eingegebenen Eingangssignals und dem Ausgangssignal zu bestimmen, und einen Aktualisierungsbetrag (Km(t+1)) des Abzweigkoeffizienten entsprechend dem verzögerten Wert des Eingangssignals auf der Basis eines vervielfachten Werts zu bestimmen, der bestimmt ist durch Vervielfachung des durch eine Kompressionsumwandlungsverarbeitung (166, 167) verarbeiteten Korrelationsbetrags mit dem genannten Fehler,

**dadurch gekennzeichnet, dass**

die Kompressionsumwandlungsverarbeitung eine arithmetische Verarbeitung ist, zur Umwandlung des Korrelationsbetrags in eine Wurzel eines Absolutwerts davon, die ein Vorzeichen des Korrelationsbetrags trägt.

2. Mehrwegentzerrungsfilter nach Anspruch 1, wobei die Kompressionsumwandlungsverarbeitung eine arithmetische Verarbeitung ist zur Umwandlung des Korrelationsbetrags in eine Quadratwurzel eines Absolutwerts davon, der ein Vorzeichen des Korrelationsbetrags trägt.

3. Mehrwegentzerrungsfilter nach Anspruch 1 oder 2, wobei
die Koeffizientenaktualisierungseinrichtung Folgendes aufweist:

einen Vervielfacher zum Vervielfachen des verzögerten Werts des Eingangssignals und des Ausgangssignals in einer fraglichen Operationsperiode;
eine Speichereinrichtung (174) zum Halten des von dem Vervielfacher bestimmten vervielfachten Werts für eine Verzögerungszeiteinheit; und
einen Addierer (165) zum Addieren des vervielfachten Werts und eines in der Speichereinrichtung gespeicherten Werts,
wobei die Koeffizientenaktualisierungseinrichtung eine Berechnung mit dem von dem Addierer bestimmten addierten Wert als dem Korrelationsbetrag durchführt.

4. Mehrwegentzerrungsfilter nach einem der Ansprüche 1, 2 und 3, wobei
die Fehlerdetektiereinrichtung Folgendes aufweist:

einen Vervielfacher (155, 161) zum Bestimmen eines Quadrats des Ausgangssignals in einer fraglichen Operationsperiode;
eine Speichereinrichtung (156, 174) zum Halten des von dem Vervielfacher bestimmten quadrierten Werts während einer Verzögerungszeiteinheit;
einen Addierer (157, 165) zum Addieren des quadrierten Werts und eines in der Speichereinrichtung gespeicherten 'Werts; und
einen Vergleicher (180) zum Vergleichen des von dem Addierer bestimmten Additionswerts (Yenv(t)) mit dem Referenzwert (Yth).

**Revendications**

1. Filtre pour éliminer des distorsions multivoies (100), comprenant :

un filtre numérique (110) ayant une pluralité de multiplicateurs de coefficient (121 à 127), chacun ayant un coefficient de dérivation (Km), destiné à appliquer un traitement d'opération de filtrage à un signal de réception numérique, comme un signal d'entrée (X(t)), contenant une composante de distorsion multivoie, afin d'éliminer la composante de distorsion et d'émettre un signal de sortie (Y(t)) ;
des moyens de détection d'erreur (150, 180) pour détecter une erreur (err(t)) entre une valeur d'enveloppe (Yenv(t)) qui est un carré de l'amplitude dudit signal de sortie (Y(t)) et une valeur de référence (Yth) ; et
des moyens de mise à jour de coefficient (160) pour calculer une caractéristique de filtre du filtre numérique afin de minimiser ladite erreur détectée, et mettre à jour chacun des coefficients de dérivation dudit filtre numérique sur la base du résultat calculé, où
lesdits moyens de mise à jour de coefficient sont adaptés pour déterminer une quantité de corrélation (Pm(t)) entre une valeur de retard (Xm(t)) dudit signal d'entrée entré sur chacun des multiplicateurs de coefficient dudit filtre numérique et ledit signal de sortie, et pour déterminer une quantité de mise à jour (Km(t + 1)) du coefficient de dérivation correspondant à la valeur de retard dudit signal d'entrée sur la base d'une valeur multipliée déterminée en multipliant ladite quantité de corrélation traitée par un traitement de conversion de compression (166, 166, 167) et ladite erreur,

**caractérisé en ce que**

ledit traitement de conversion de compression est un traitement arithmétique pour convertir la quantité de corrélation en une racine d'une valeur absolue de celle-ci à laquelle un signe de la quantité de corrélation est attaché.

2. Filtre pour éliminer des distorsions multivoies selon la revendication 1, dans lequel ledit traitement de conversion de compression est un traitement arithmétique pour convertir la quantité de corrélation en une racine carrée d'une valeur absolue de celle-ci à laquelle un signe de la quantité de corrélation est attaché.

3. Filtre pour éliminer des distorsions multivoies selon la revendication 1 ou 3, dans lequel lesdits moyens de mise à jour de coefficient comprennent :

un multiplicateur (161) pour multiplier ladite valeur de retard dudit signal d'entrée et dudit signal de sortie dans une période de fonctionnement en question ;

des moyens de stockage (174) pour conserver la valeur multipliée déterminée par ledit multiplicateur pendant un temps de retard unitaire ; et

un additionneur (165) pour ajouter la valeur multipliée et une valeur stockée qui est stockée dans lesdits moyens de stockage,

dans lequel lesdits moyens de mise à jour de coefficient effectuent un calcul avec la valeur ajoutée déterminée par ledit additionneur comme la quantité de corrélation.

4. Filtre pour éliminer des distorsions multivoies selon l'une quelconque des revendications 1, 3, et 4, dans lequel lesdits moyens de détection d'erreur comprennent :

un multiplicateur (155, 161) pour déterminer un carré dudit signal de sortie dans une période de fonctionnement en question ;

des moyens de stockage (156, 174) pour conserver la valeur au carré déterminée par ledit multiplicateur pendant un temps de retard unitaire ;

un additionneur (157, 165) pour ajouter la valeur au carré et une valeur stockée qui est stockée dans lesdits moyens de stockage ; et

un comparateur (180) pour comparer la valeur ajoutée (Yenv(t)) déterminée par ledit additionneur à ladite valeur de référence (Yth).

# FIG.1

## PRIOR ART

DELAY UNIT

X(t)

COEFFICIENT MULTIPLIER

K0(t)    K1(t)    K2(t)    Km(t)   Km+1(t)    KN-2(t)    KN-1(t)

COEFFICIENT
UPDATING MEANS

err

Y(t)

REFERENCE VALUE

$|Y|^2$

ENVELOPE
DETECTION

EP 1 508 969 B1

# FIG.2

EP 1 508 969 B1

**FIG.3**

# FIG.4 A

# FIG.4 B

# FIG.5

FIG.6

# FIG.7 A

FM INPUT SIGNAL    FILTER OUTPUT SIGNAL    FM DETECTION SIGNAL

t=0                                                              t=10ms

RESPONSE BY RECEIVER ON WHICH PRESENT
ADAPTIVE FILTER IS MOUNTED

# FIG.7 B

FM INPUT SIGNAL    FILTER OUTPUT SIGNAL    FM DETECTION SIGNAL

t=0                                                              t=10ms

RESPONSE BY RECEIVER ON WHICH CONVENTIONAL
ADAPTIVE FILTER IS MOUNTED

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **V.Y. YANG et al.** A Vector Constant Modulus Algorithm for Shaped Constellation Equalization. *IEEE Signal Processing Letters,* April 1998, vol. 5 (4), 89-91